Europäisches Patentamt

European Patent Office

Office européen des brevets

(11) Publication number: **0 230 788 B1**

# EUROPEAN PATENT SPECIFICATION

(45) Date of publication of patent specification: **06.03.91**

(51) Int. Cl.5: **C23C 16/30, C23C 14/24, C23C 16/42, //G01N21/64, H01L21/205**

(21) Application number: **86310161.4**

(22) Date of filing: **24.12.86**

(54) Method for preparation of multi-layer structure film.

(30) Priority: **28.12.85 JP 298042/85**

(43) Date of publication of application:
**05.08.87 Bulletin 87/32**

(45) Publication of the grant of the patent:
**06.03.91 Bulletin 91/10**

(84) Designated Contracting States:
**DE FR GB IT NL**

(56) References cited:
**EP-A- 0 138 332       EP-A- 0 140 660**
**DE-A- 2 538 300       DE-A- 3 509 910**
**FR-A- 2 555 206       US-A- 4 504 518**
**US-A- 4 539 934       US-A- 4 615 905**

**Patent Abstracts of Japan, unexamined applications, C field, vol. 10, no. 90. April 8, 1986 - The Patent Office Japanese Government, page 87 C 337**

**Patent Abstracts of Japan, unexamined applications, C field, vol. 9, no. 222, September 9, 1985 - The Patent Office Japanese Government, page 26 C 302**

(73) Proprietor: **CANON KABUSHIKI KAISHA**
**30-2, 3-chome, Shimomaruko, Ohta-ku Tokyo(JP)**

(72) Inventor: **Ishihara, Shunichi,**
**600-5-7-404, Kashiwagaya**
**Ebina-shi Kanagawa-ken(JP)**
Inventor: **Hanna, Jun-ichi**
**5780, Nagatsuta-cho Midori-ku**
**Yokohama-shi Kanagawa-ken(JP)**
Inventor: **Shimizu, Isamu**
**20-3-501, Edaminami 5-chome Midori-ku**
**Yokohama-shi Kanagawa-ken(JP)**

(74) Representative: **Beresford, Keith Denis Lewis et al**
**BERESFORD & Co. 2-5 Warwick Court High Holborn**
**London WC1R 5DJ(GB)**

**Description**

BACKGROUND TO THE INVENTION

FIELD OF THE INVENTION

This invention relates to a method for preparing a functional film. In particular, it relates to the preparation of a film of multi-layer structure that is useful for example in electronic devices such as semiconductor devices, photosensitive devices for electrophotography, and optical input sensor devices for inputting optical images.

RELATED BACKGROUND ART

Devices using amorphous or polycrystalline deposited films of multi-layer structure, e.g. semiconductor films, insulating films, photoconductive films, magnetic films or metal films can be expected to have physical characteristics or uses different from deposited films of single layer structure and therefore have been studied aggresively in recent years. In particular, films of multi-layer structure in which two or more different amorphous layers are laminated together are attracting interest, particularly from the standpoint of large area devices. For the production of a solar battery or other devices, investigations have been made into use of a chemical vapour disposition methods (CVD) such as plasma CVD or optical CVD in the production of films of multi-layer structure in which layers of amorphous silicon (a-Si) alternate with layers of amorphous silicon carbide (a-SiC), or in which amorphous silicon layers alternate with layers of amorphous silicon germanium (a-SiGe).

The use of the plasma CVD method to form a deposited film is now accepted as the best method from the standpoints of productivity and the properties of the resultant film, and it has been widely used for the production of solar batteries and electrophotographic photosensitive members, even though there are problems such as ambiguities in the reaction mechanism. Formation of a deposited film is influenced by a large number of parameters, for example substrate temperature, flow rate and the flow ratio of the gases introduced, the pressure during film formation, the high frequency power used, the electrode structure, the structure of the reaction vessel, the speed of evacuation and the plasma generating system used. Some combinations of these many parameters give rise to a plasma of unstable state which often has a marked deleterious influence on the deposited film formed.

In particular, when the plasma CVD is used to form a film of multi-layer structure each time that the layer is changed, it is necessary to adjust the discharge or the gas introduction. A significant change in the amount of gas introduced gives rise to a pressure change within the reaction space so that the discharge becomes unstable which badly affects the structure and characteristics of the resulting film. If it is attempted to make a multi-layer structure by maintaining the discharge and adjusting only the amount of gas introduced, as has been proposed in the prior art, it is difficult to control the conditions so that films having good characteristics can be obtained consistently.

In the alternative method, in which the gases being introduced are changed over with the discharge being turned off, and discharge only being resumed after the pressure has reached equilibrium, the problem arises that the change-over is extremely time consuming which is a disadvantage from the standpoint of productivity. Furthermore, in plasma discharge, the discharge does not generally become stable immediately after it has been turned on, so that the interface characteristics of the multi-layer film obtained are poor.

The present invention provides a method for forming a multi-layer film structure on a substrate in a reaction space by applying discharge energy to gaseous starting materials in the reaction space to effect film formation by chemical vapour deposition, characterised in that:

(a) a first layer of film having a first composition is deposited on the substrate by separately introducing into the reaction space a first gaseous starting material at a first flow rate (A), a second gaseous starting material at a second flow rate (B) and externally activated hydrogen so as to form a mixture which chemically reacts and produces the first layer, the second gaseous starting material being introduced into the reaction space at a flow rate that is at most half of that of the flow rate of the first gaseous starting material; and

2

(b) whilst maintaining the application of discharge energy to the gaseous starting materials said second flow rate (B) is varied so as to make the flow rate (B) at most half of the flow rate (A) of the first gaseous starting material to Produce at least a second layer of deposited film on the first layer, the second layer having a composition different from that of the first layer.

The above method may provide excellent productivity and bulk productivity, and may give a film of high quality with good physical characteristics, e.g electrical, optical and semiconductor characteristics.

The use of plasma CVD to form films of multi-layer structure is disclosed in US Patent Nos. 4504518 and 4615905, but these references do not disclose maintaining the application of discharge energy to the gaseous starting materials during alteration of the gaseous starting materials, do not identify the problem of pressure change within the reaction space when the gaseous starting materials are altered and do not disclose the present relationship between the flow rates of the gaseous starting materials.

BRIEF DESCRIPTION OF THE DRAWINGS

The invention will now be further described, by way of example, with reference to the accompanying drawings in which:

Fig.l illustrates schematically an example of the device for practising the method of preparation of multi-layer structure film of the present invention.

DESCRIPTION OF THE PREFERRED EMBODIMENTS

The above object can be accomplished by a method for preparing a multi-layer structure film by forming a deposited film according to the chemical vapor deposition method, which comprises introducing a subjective starting material gas (A) which is the major flow rate component and an objective starting material gas (B) which is the minor flow rate component and hydrogen externally activated into a reaction space and controlling periodically the amount of said objective starting material gas (B) introduced to thereby form a deposited film with a multi-layer structure.

According to the method for forming a deposited film of the present invention, a multilayer structure film having good film characteristics can be obtained simultaneously with simplification of management and bulk production with full satisfaction of enlargement of area, uniformity of film thickness and uniformity of film quality, without requiring enormous installation investment for bulk-production apparatus, and also the management items for its production become clear to afford broad management tolerance and simple control of the device.

According to the method for preparation of a multi-layer structure film of the present invention, a multi-layer structure film constituted of two or more kinds of layers such as a multi-layer film having two kinds of layers with different physical properties laminated alternately can be prepared easily and rapidly. Also, a multi-layer structure film can be prepared with each layer being made an extremely thin layer of, for example, l0 Å to 200 Å.

The amount (b) of the objective starting material gas (B) which is the minor flow rate component to be introduced into the reaction space relative to the amount (a) of the subjective starting material gas (A) which is the above mentioned major flow rate component is made 1/2(a) or less, and preferably 1/10(a) or less.

The subjective starting material gas (A) can be constituted of a gas comprising an element contained in the layers forming the multi-layer structure, for example, both of the two layers with different physical properties, and can be constituted of a gas which must be introduced into the reaction space in an extremely large amount as compared with the objective starting material gas (B) because of remarkably smaller reactivity as compared with the objective starting material gas (B).

On the other hand, the objective starting material gas (B) can be constituted of a gas comprising an element contained in one of the layers forming the multi-layer structure, for example, the two layers with different physical properties, and can be constituted of a gas which may be introduced in smaller amount as compared with the subjective starting material gas (A) because of remarkably greater reactivity as compared with the subjective starting material gas (A).

In case a multi-layer structure film with such two kinds of gases is prepared, when forming a film containing the elements of, for example, "A" and "B", even if the subjective starting material gas (A) may be introduced in larger amount and the objective starting gas (B) in smaller amount, a film comprising elements of "A" and "B" with approximately equal elemental ratio is obtained as the result of glow discharging decomposition.

In addition, in the present invention, even when introduction of the objective starting material gas (B) into the reaction chamber is then stopped to form a film consisting only of the element of "A", the pressure change within the reaction chamber is extremely small.

Referring specifically to the case of preparation of a multi-layer structure film composed primarily of Si element, such as a multi-layer structure film of a-Si and a-SiGe, or a multi-layer structure film of a-Si and a-SiC, the subjective starting material gas (A) may be a silicon compound such as $SiF_4$, $SiCl_4$, $SiF_2Cl_2$, etc. On the other hand, examples of the starting material gas (B) may include germanium compounds such as $GeF_4$, $GeF_2Cl_2$, $GeCl_4$, etc., and carbon compounds such as $CF_4$, $C_2F_6$, $CCl_4$, etc.

For example, when a-SiGe film is to be prepared from $SiF_4$ and $GeF_4$, $SiF_4$ and $GeF_4$ may be permitted to flow at a ratio, which may differ depending on the amount of physical properties demanded for the multi-layer structure film to be formed, but is generally 10 : 1, namely 10 or more desirably 100 : 1, namely 100 or more.

Whereas, when a silicon halide-based starting gas is to be employed, since the gas of a silicon halide compound has itself substantially no ability to form a film, its film forming ability must be enhanced by introducing hydrogen gas together with the silicon halide gas and permitting the active species of hydrogen generated by decomposition by glow discharging and the active species of the silicon halide compound to react with each other.

On the other hand, the quality of the film formed depends on the amounts of the activated species of hydrogen and the activated species of silicon halide in the plasma. The amount of hydrogen gas introduced may be generally within the limited range from 1/4' to 1 of the flow rate of $SiF_4$.

Also, when a mixture of $SiF_4$ and hydrogen is decomposed by glow discharge to change arbitrarily the mixing ratio of the active species from $SiF_4$ and the active species of hydrogen, since both $SiF_4$ and hydrogen are decomposed by glow discharge, it is difficult to change arbitrarily the mixing ratio of the active species from $SiF_4$ and the active species of hydrogen, that is, to set freely the mixing ratio of the active species in the plasma.

For this reason, in the present invention, by introducing active species of hydrogen in place of hydrogen gas into the reaction space, the amount of the active species is controlled.

By doing so, even if the flow rate of the active species of hydrogen may be changed, for example, between 0.01 and 66% of the flow rate of $SiF_4$, film formation can be done at any mixing ratio. The characteristics of the film can be controlled by the amount of the active species of hydrogen introduced.

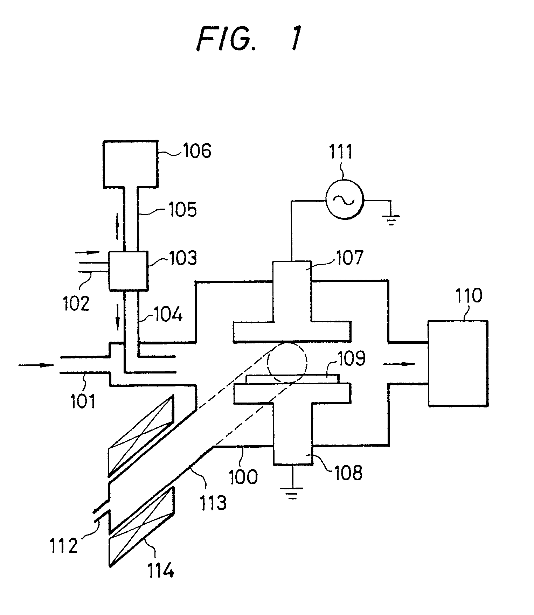

Fig. 1 shows an example of a preferable device for practicing the method for forming a deposited film of multi-layer structure of the present invention.

101 is an introducing inlet for the subjective starting gas and 102 an introducing inlet for the objective starting gas. 103 is an electromagnetic valve of three-way cock, which is connected to a gas introducing pipe 104 connected to within the reaction chamber 100 or gas discharging pipe 105 connected to the evacuation device 106. 107 is an electrode connected to the RF power source 111, having a structure capable of exciting glow discharging plasma with the electrode 108 below. 109 is a substrate. 110 is a vacuum evacuation device for evacuating the reaction chamber.

112 is an inlet for introducing $H_2$, which is connected to a reaction pipe 113 made of a quartz pipe, the reaction pipe 113 is placed in a cavity 114 of microwave, and by application of microwave power on the cavity 114, plasma is excited to decompose the $H_2$ molecules within the reaction pipe 113 to activated H atoms. The decomposed H atoms are introduced into the reaction chamber 100.

The present invention is described in detail by referring to Examples.

Example 1

By use of the device for forming a deposited film shown in Fig. 1, a reading sensor having a multi-layer structure film of a-SiGe:H(F) film and a-Si:H(F) film was formed. Through the gas introducing pipe 101, $SiF_4$ gas and $H_2$ gas as the subjective starting material gases were introduced into the chamber 100. Also, through the gas introducing pipe 102, $GeF_4$ gas was also introduced into the chamber 100 as the objective starting material. To the gas introducing pipe 102 was connected an electromagnetic valve 103 equipped with a three-way valve, so that the gas introducing pipe 102 may be changed over selectively by electrical signals to be connected to the gas introducing pipe 104 or to the gas discharging pipe 105. Also, through the gas introducing pipe 112, hydrogen gas was introduced into the reaction pipe 113, and microwave power was applied on the microwave cavity 114 to excite plasma within the reaction pipe 113. The hydrogen atom radicals formed were introduced into the reaction chamber. The gas discharging pipe 105 was connected to the vacuum evacuating device 106.

With such a device constitution, GeF$_4$ gas always at a constant flow rate was introduced intermittently by electrical signals into the chamber. The gas introduced was subjected to glow discharge decomposition by high frequency power of 13.56 MHz applied between the electrodes 107 and 108, whereby through the chemical reaction of the radicals generated with H atoms, a multi-layer structure film of a-SiGe:H(F) and a-Si:H(F) was deposited on a glass substrate (Corning 7059).

The gas not contributed to the film formation are discharged out of the chamber by the vacuum evacuation device 110.

In the following, the method for preparation of a reading sensor comprising a multi-layer structure of a-SiGe:H(F) film and a-Si:H(F) film within the sensor is to be described.

SiF$_4$ gas was introduced at 39.73 sccm through the gas introducing pipe 101, and GeF$_4$ gas at 0.4 sccm through the gas introducing gas 102 into the chamber. Through the gas introducing pipe 112, H$_2$ gas was introduced at 0.6 sccm and He gas at 10 sccm into the reaction pipe 113, and microwave power of 300 W was applied on the microwave cavity 114. As a result, plasma was generated in the reaction pipe.

As the substrate, Corning 7059 gas was employed. The glass substrate temperature was set at 300 $^\circ$C.

The pressure in the chamber was 300 mTorr and the difference between the case when GeF$_4$ was flowed and the case when no GeF$_4$ was flowed was within 2 mTorr. With this state, 30 W of high frequency power of 13.56 MHz was applied (power density 1 W/cm$^2$).

Even if the flow of GeF$_4$ was turned on or off, substantially no change was observed in the discharged state.

Under this state, the three-way valve,on the introducing pipe of GeF$_4$ was changed over every 30 seconds. After repeating on-off of the three-way valve for about 200 times, discharging was stopped with stopping of gas feeding, and the substrate was cooled to room temperature and taken out from the reaction chamber. After equipped with a comb-shaped electrode of aluminum (gap length 200 $\mu$m) in another vacuum vapor deposition device, the sample was placed in a vacuum cryostat, and dark electroconductivity ($\sigma$d) and electroconductivity $\sigma$p during photoirradiation of 600 nm, 0.3 mW/cm were measured.

The values obtained were as follows.

$\sigma$d = 5 x 10$^{-13}$ S/cm

$\sigma$p = 4 x 10$^{-6}$ S/cm

Thus, an optical sensor with an extremely good $\sigma$p/$\sigma$d ratio was obtained.


Example 2

By use of the device shown in Fig. 1, an optical diode of PIN structure was prepared on a glass substrate having an ITO film of 1000 Å deposited thereon. After the substrate was set, the substrate temperature was maintained at 250 $^\circ$C. First, through the gas introducing pipe 101, SiF$_4$ gas added with 3000 ppm of B$_2$H$_6$ as the subjective starting material gas was introduced at 35 sccm into the chamber 100.

Also, through the gas introducing pipe 102, C$_2$F$_6$ gas was introduced as the objective starting material gas at 5 sccm into the chamber 100. At the same time, H$_2$ gas at 1 sccm and He gas at 10 sccm were introduced through the gas introducing pipe 112 into the reaction pipe 113, and microwave of 300 W was applied. A high frequency power of 30 W was applied from RF power source on the electrode 107 to establish plasma. The three-way valve connected to the gas introducing pipe 102 was turned on for 50 seconds and off for 25 seconds, which on-off cycle was repeated three times. As the result, a p-type film of a multi-layer structure of an a-SiC layer with a thickness of about 50 Å and an a-Si layer with a thickness of about 50 Å was formed to about 300 Å. Then, after C$_2$F$_6$ gas was replaced with GeF$_4$ gas, under the same conditions as described in Example 1, a non-deoped multi-layer film of a-SiGe layer and a-Si layer was formed to about 9000 Å. Then, after the flow of GeF$_4$ gas was stopped, SiF$_4$ gas added with 3000 ppm of PH$_3$ was introduced at 40 sccm through the gas introducing pipe 101 into the chamber, H$_2$ gas at 0.6 sccm and He gas at 10 sccm through the gas introducing pipe 112 into the chamber, and 300 W of microwave was applied to establish plasma in the reaction pipe 113, and a high frequency power of 30 W was applied for 5 minutes to form a n-type a-Si film of about 300 Å thereon. After evacuating the gas thoroughly, the substrate was left to cool to room temperature, followed by vapor deposition of an aluminum electrode of 10 mm in diameter.

As a result, an optical diode of PIN structure comprising a glass substrate/ITO film/a p-type multi-layer structure film of a-SiC and a-Si/a nondoped multi-layer structure film of a-SiGe and a-Si/a n-type a-Si film/A1 was formed. When the solar battery characteristics were measured by irradiation of light of AM-1, 100 mW/cm$^2$ , good values of an open circuit voltage of 1.0 v, a short circuit current of 16 mA/cm$^2$ and a

conversion efficiency of 9.8% were obtained.

Example 3

On an aluminum substrate, according to the procedure shown in Table 1, an electrophotographic photosensitive member was formed from A1 substrate/ p-type a-Si layer/multi-layer film of a-SiGe and a-Si/multi-layer film of a-SiC and a-Si.

-` Table 1

| Layer | Starting material gas | | Film thickness |
|---|---|---|---|
| p-type a-Si layer | $SiF_4$ with 3000 ppm $B_2H_6$ added | 35 sccm | 1 μ |
| | $H_2$ | 0.6 sccm | |
| | He | 10 sccm | |
| Multi-layer film a-SiGe/a-Si | $SiF_4$ | 39.75 sccm | 20 μ |
| | $H_2$ | 0.6 sccm | |
| | He | 10 sccm | |
| | $GeF_4$ | 0.4 sccm | |
| | (on/off 50 sec. interval) | | |
| Multi-layer film a-SiC/a-Si | $SiF_4$ | 35 sccm | 5000 Å |
| | $H_2$ | 0.6 sccm | |
| | He | 10 sccm | |
| | $C_2F_6$ | 5 sccm | |
| | (on 100 sec., off 50 sec. interval) | | |

$SiF_4$ and $H_2$ gas were introduced through the introducing pipe 101, $GeF_4$ and $C_2F_6$ through the gas introducing pipe 102 and introduction of the gases into the reaction chamber was controlled by the three-way valve.

$H_2$ gas and He gas were introduced through the gas introducing pipe 112, microwave power of 300 W was applied to generate plasma in the reaction pipe 113 to form activated H atoms, which were then introduced into the reaction chamber 120.

Other film forming conditions were as follows:
inner pressure 300 m torr;
substrate temperature 250 °C.

When this electrophotographic photosensitive member was subjected to ⊕ corona charging for 0.2 sec., an acceptance potential of 380 v was obtained.

Then, when it was exposed to a semiconductor laser beam of 788 nm with an optical density of $2\mu J$, the potential became 30v.

As described in detail above, according to the method for preparation of a multi-layer structure film of the present invention, characteristics can be remarkably improved. Also, the method of the present invention is easy in control of the production conditions and the process, and therefore suitable for bulk production.

**Claims**

1. A method for forming a multi-layer film structure on a substrate in a reaction space by applying discharge energy to gaseous starting materials in the reaction space to effect film formation by chemical vapour deposition, characterised in that:

(a) a first layer of film having a first composition is deposited on the substrate by separately introducing into the reaction space a first gaseous starting material at a first flow rate (A), a second gaseous starting material at a second flow rate (B) and externally activated hydrogen so as to form a mixture which chemically reacts and produces the first layer, the second gaseous starting material being introduced into the reaction space at a flow rate that is at most half of that of the flow rate of the first gaseous starting material; and

(b) whilst maintaining the application of discharge energy to the gaseous starting materials said second flow rate (B) is varied so as to make the flow rate (B) at most half of the flow rate (A) of the first gaseous starting material to produce at least a second layer of deposited film on the first layer, the second layer having a composition different from that of the first layer.

2. A method according to claim 1 or 2, wherein each layer of the multi-layer film structure formed has a thickness of from 10Å to 200Å.

3. A method according to any preceding claim, wherein the first gaseous starting material comprises a silicon compound.

4. A method according to any of claims 1-3, wherein hydrogen gas is present in the first gaseous starting material.

5. A method according to any preceding claim, wherein the second gaseous starting material comprises a germanium compound.

6. A method according to any of claims I-4, wherein the second gaseous starting material comprises a carbon compound.

7. A method according to any of claims 1-4, wherein the second gaseous starting material comprises activated hydrogen atoms.

8. A method according to any preceding claim, wherein the multi-layer film structure includes at least one layer selected from a-Si, a-SiGe and a-SiC.

9. A method according to any preceding claim, wherein the multi-layer film structure includes at least one n-type or p-type layer.

10. A method according to any preceding claim, wherein the second flow rate (B) is periodically adjusted to zero.

**Revendications**

1. Procédé pour former une structure de film multicouche sur un substrat dans un espace de réaction en appliquant une énergie de décharge à des matières gazeuses de départ dans l'espace de réaction pour réaliser une formation de film par dépôt chimique en phase vapeur, caractérisé en ce que :

(a) une première couche de film ayant une première composition est déposée sur le substrat par l'introduction séparée dans l'espace de réaction d'une première matière gazeuse de départ à un premier débit d'écoulement (A), d'une seconde matière gazeuse de départ à un second débit d'écoulement (B) et d'hydrogène activé extérieurement afin de former un mélange qui réagit chimiquement et produit une première couche, la seconde matière gazeuse de départ étant introduite dans l'espace de réaction à un débit d'écoulement qui est au plus égal à la moitié du débit d'écoulement de la première matière gazeuse de départ ; et

(b) tout en maintenant l'application d'une énergie de décharge aux matières de gaz de départ, ledit second d'écoulement (B) est modifié de façon à rendre le debit d'écoulement (B) au plus égal à la moitié du débit d'écoulement (A) de la première matière gazeuse de départ pour produire au moins une seconde couche d'un film déposé sur la première couche, la seconde couche ayant une composition différente de celle de la première couche.

2. Procédé selon la revendication 1 ou 2, dans lequel chaque couche de la structure de film multicouche formée présente une épaisseur de 10 Å à 200 Å.

3. Procédé selon l'une des revendications précédentes, dans lequel la première matière gazeuse de départ comprend un composé de silicium.

4. Procédé selon l'une quelconque des revendications 1-3, dans lequel de l'hydrogène à l'état gazeux est présent dans la première matière gazeuse de départ.

5. Procédé selon l'une quelconque des revendications précédentes, dans lequel la seconde matière gazeuse de départ comprend un composé de germanium.

6. Procédé selon l'une quelconque des revendications 1-4, dans lequel la seconde matière gazeuse de départ comprend un composé de carbone.

7. Procédé selon l'une quelconque des revendications 1-4, dans lequel la seconde matière gazeuse de départ comprend des atomes d'hydrogène activé.

8. Procédé selon l'une quelconque des revendications précédentes, dans lequel la structure de film multicouche comprend au moins une couche choisie parmi les a-Si, a-SiGe et a-SiC.

9. Procédé selon l'une quelconque des revendications précédentes, dans lequel la structure de film multicouche comprend au moins une couche de type n ou de type p.

10. Procédé selon l'une quelconque des revendications précédentes, dans lequel le second débit d'écoulement (B) est réglé périodiquement à zéro.

**Ansprüche**

1. verfahren zur Bildung einer mehrschichtigen Filmstruktur auf einem Substrat in einer Reaktionskammer durch Anlegen von Entladungsenergie an ein gasförmiges Ausgangsmaterial in der Reaktionskammer, um die Bildung eines Films durch chemische Dampfabscheidung zu bewirken, dadurch gekennzeichnet, daß

(a) eine erste Filmschicht mit einer ersten Zusammensetzung auf dem Substrat dadurch abgeschieden wird, daß getrennt voneinander in die Reaktionskammer bei einer ersten Flußrate (A) ein erstes gasförmiges Ausgangsmaterial, bei einer zweiten Flußrate (B) ein zweites gasförmiges Ausgangsmaterial sowie extern aktivierter Wasserstoff zugeführt wird, so daß sich eine Mischung bildet, die chemisch reagiert und die erste Schicht erzeugt, wobei das zweite gasförmige Ausgangsmaterial der Reaktionskammer bei einer Flußrate zugeführt wird, die höchstens die Hälfte der Flußrate des ersten gasförmigen Ausgangsmaterials beträgt; und,

(b) während das Anlegen von Entladungsenergie an die gasförmigen Ausgangsmaterialien beibehalten wird, die zweite Flußrate (B) so variiert wird, daß sie höchstens die Hälfte der Flußrate (A) des ersten gasförmigen Ausgangsmaterials beträgt, um zumindest eine zweite abgeschiedene Filmschicht auf der ersten zu erzeugen, die sich in der Zusammensetzung von der der ersten Schicht unterscheidet.

2. Verfahren nach Anspruch 1, dadurch gekennzeichnet, daß jede Schicht der gebildeten mehrschichtigen Filmstruktur eine Dicke von 10 A bis 200 A hat.

3. Verfahren nach einem der vorhergehenden Ansprüche, dadurch gekennzeichnet, daß das erste gasförmige Ausgangsmaterial eine Siliciumverbindung umfaßt.

4. Verfahren nach einem der Ansprüche 1 bis 3, dadurch gekennzeichnet, daß Wasserstoffgas im ersten gasförmigen Ausgangsmaterial vorhanden ist.

5. Verfahren nach einem der vorhergehenden Ansprüche, dadurch gekennzeichnet, daß das zweite gasförmige Ausgangsmaterial eine Germaniumverbindung enthält.

6. Verfahren nach einem der Ansprüche 1 bis 4, dadurch gekennzeichnet, daß das zweite gasförmige Ausgangsmaterial eine Kohlenstoffverbindung enthält.

7. Verfahren nach einem der Ansprüche 1 bis 4, dadurch gekennzeichnet, daß das zweite gasförmige Ausgangsmaterial aktivierte Wasserstoffatome enthält.

8. Verfahren nach einem der vorhergehenden Ansprüche, dadurch gekennzeichnet, daß die mehrschichtige Filmstruktur zumindest eine Schicht, ausgewählt aus a-Si, a-SiGe und a-SiC, enthält.

9. Verfahren nach einem der vorhergehenden Ansprüche, dadurch gekennzeichnet, daß die mehrschichtige Filmstruktur zumindest eine Schicht vom n-Typ oder p-Typ enthält.

10. Verfahren nach einem der vorhergehenden Ansprüche, dadurch gekennzeichnet, daß die zweite Flußrate periodisch auf Null eingestellt wird.

# FIG. 1